# FASCICULE DE BREVET EUROPEEN

(11) **EP 1 615 344 B1**
(45) Date de publication et mention de la délivrance du brevet: **10.10.2007**
(21) Numéro de dépôt: 05300566.6
(22) Date de dépôt: 07.07.2005
(51) Int. Cl.: H03M 11/20

(54) **Clavier de saisie à nombre de touches accru, pour un équipement électronique à nombre de pattes de connexion limité**
Eingabetastatur mit erhöhter Anzahl von Tasten, für ein elektronisches Gerät mit begrenzter Anzahl von Anschlüssen
Keyboard with increased number of keys for an electronic device having a limited number of connecting pins

(30) Priorité: 09.07.2004 FR 0451483
(43) Date de publication de la demande: 11.01.2006
(73) Titulaire: TCL & Alcatel Mobile Phones Limited, Tsimsha Tsui Kowloon (CN)
(72) Inventeur: Barthelet, Philippe, 92270, Bois-Colombes (FR); Dalla Rica, Eric, 92707, Colombes (FR); Vetu, Pascal, 92707, Colombes (FR)
(74) Mandataire: Hervouet, Sylvie

(56) Documents cités:
- EP-A- 0 427 364
- US-A- 4 395 704
- US-A- 4 408 184
- US-A- 4 583 092
- US-A1- 2002 167 494
- TIETZE, SCHENK: "Halbleiter-Schaltungstechnik" 1999, SPRINGER VERLAG , XP002320922 ISBN: 3-540-64192-0 * alinéa [8.2.1] *

## Description

L'invention concerne le domaine des claviers de saisie.

De nombreux équipements électroniques comportent un microprocesseur couplé à un clavier muni de touches de saisie permettant à leurs utilisateurs de leur adresser des instructions ou des commandes. Par exemple, certaines touches peuvent être dédiées à la saisie d'une lettre d'un alphabet et/ou d'un chiffre et/ou d'un signe de ponctuation, tandis que d'autres touches peuvent être dédiées à des opérations de déplacement dans des directions choisies (on parle alors de touches de « navigation »).

On entend ici par « équipement électronique » tout équipement muni d'une interface homme/machine permettant la saisie d'informations ou de commandes, comme par exemple un ordinateur fixe ou portable (éventuellement de type embarqué), un téléphone fixe ou mobile, un assistant personnel numérique (ou PDA pour « Personal Digital Assistant »), un dispositif de guidage ou de navigation, ou une console de jeux vidéo.

Afin que le microprocesseur puisse déterminer (ou reconnaître) une touche de saisie venant d'être actionnée, il dispose d'un certain nombre de pattes de connexion (ou « pins ») auxquelles sont couplées, par exemple via un bus, des bornes de connexion, elles-mêmes raccordées à des lignes conductrices couplées aux différentes touches.

Le nombre de pattes de connexion du microprocesseur étant limité, il a été proposé un clavier à architecture de connexion « en grille ». Ce type de clavier comprend plus précisément i) des lignes conductrices primaires et secondaires raccordées chacune respectivement à des plots de connexion dits primaires et secondaires et à une borne de connexion destinée à être couplée à un microprocesseur d'équipement, et ii) des touches de saisie pouvant chacune établir, en cas d'actionnement, un contact entre l'un des plots primaires de l'une des lignes primaires et l'un des plots secondaires de l'une des lignes secondaires de manière à placer ces deux lignes primaire et secondaire dans un état logique dit « haut » (par exemple égal à 1). Lorsque le microprocesseur détecte des états hauts sur deux de ses pattes de connexion, il n'a plus qu'à accéder à une table, établissant une correspondance entre des identifiants de touche, des identifiants de lignes primaires et des identifiants de lignes secondaires, pour déterminer l'identifiant de la touche actionnée ayant provoquée le placement dans l'état haut des bornes de connexion couplées aux deux pattes de connexion.

Par exemple, le microprocesseur détecte un court-circuit, entre une ligne secondaire (servant par exemple d'entrée) et une ligne primaire (servant par exemple de sortie), provoqué par l'établissement d'un contact entre un plot primaire de cette ligne primaire et un plot secondaire de cette ligne secondaire, au moyen d'une touche. Bien entendu, d'autres types de détection peuvent être envisagés, dès lors qu'ils reposent sur l'absence ou la présence d'un «signal » analogique (comme par exemple un potentiel électrique) ou numérique.

Grâce à l'architecture en grille (ou matricielle) présentée ci-avant, le nombre maximal K de touches pouvant être gérées par un microprocesseur de P pattes de connexion est égal au produit du nombre N de lignes de connexion primaires par le nombre M de lignes de connexion secondaires (K = NxM), avec la contrainte P = N + M. Par exemple, un microprocesseur de P = 10 pattes de connexion peut gérer au plus K = 25 touches (lorsque N = M = 5).

Le nombre de touches de saisie du clavier de certains équipements ne pouvant pas être augmenté du fait que le nombre de pattes de connexion de leur microprocesseur ne peut être augmenté, l'ajout de fonctions ou commandes additionnelles nécessite par exemple la configuration du microprocesseur de sorte qu'il puisse associer chaque fonction ou commande additionnelle à l'actionnement d'au moins deux touches.

Par exemple, lorsque le clavier comporte quatre touches de navigation, associées à quatre directions de déplacement dites « principales » (nord, sud, est et ouest), et que l'on souhaite définir des directions de déplacement dites « intermédiaires » (nord/est, nord/ouest, sud/est et sud/ouest), on doit configurer le microprocesseur pour qu'il associe chaque direction intermédiaire à l'actionnement successif des deux touches de navigation qui sont associées à la combinaison de directions principales qui la définissent. Par exemple, si l'équipement dispose d'une fonction de navigation couplée à un « joystick » et que l'utilisateur oriente son joystick dans la direction nord/est, le joystick doit actionner les touches nord et est sous-jacentes dans un délai prédéfini pour que le microprocesseur l'interprète comme un double appui et comprenne que la direction nord/est est demandée.

Or, la direction dans laquelle est pointé le joystick ne correspond pas toujours à la direction théorique dans laquelle ledit joystick est en mesure d'appuyer sur les deux touches effectivement concernées (dans le délai imparti). Par conséquent, lorsque le joystick n'appuie que sur l'une des deux touches, le microprocesseur comprend que la direction demandée est celle qui correspond à la touche activée, ce qui constitue une erreur.

En outre, ce double actionnement peut s'avérer incompatible avec certaines utilisations requérant une saisie rapide de commandes, comme par exemple dans certains jeux vidéo.

L'invention a donc pour but d'améliorer la situation.

Elle propose à cet effet un clavier de saisie tel que défini dans la revendication 1.

Le document US 4 395 704 A décrit un clavier de saisie pour une calculatrice de poche (cf. figures 3 et 4) comportant une matrice standard consistant d'un ensemble de cinq lignes primaires d'une part et de six lignes secondaires d'autre part, ce qui permet un maximum de 30 touches. Pour ajouter des touches à cette matrice, certaines intersections entre des lignes primaires et secondaires comportent deux touches, ce qui induit une ambiguïté et impose l'utilisation d'une touche de mode.

Le document EP 0 427 364 A décrit un clavier de saisie (cf. figure 3) comportant un décodeur entre le microprocesseur et les lignes primaires, permettant de connecter trois pattes du microprocesseur à huit lignes primaires. Cette couche supplémentaire, prévue pour ajouter un grand nombre de touches, est relativement complexe et impose des changements substantiels dans séquence de détection.

L'invention s'applique à tout type de détection, dès lors qu'il porte sur l'absence (par exemple état bas) ou la présence (par exemple état haut) d'un signal analogique (comme par exemple un potentiel électrique) ou numérique.

Le clavier selon l'invention peut comporter des caractéristiques complémentaires qui peuvent être prises séparément ou en combinaison, et notamment :
- ses premiers et seconds moyens de traitement peuvent être chacun agencés sous la forme d'un multiplexeur, dont la deuxième entrée est une entrée de commande et qui comprend une troisième entrée placée en permanence dans un état haut et pouvant être couplée à la sortie lorsque la troisième ligne secondaire supplémentaire est dans son état haut, la première entrée étant couplée à la sortie lorsque la ligne secondaire supplémentaire n'est pas dans son état haut,
- au moins quatre lignes conductrices primaires raccordées chacune à un nombre choisi de plots primaires de connexion et à une borne de connexion destinée à être couplée au microprocesseur, et au moins cinq lignes conductrices secondaires dans la second ensemble raccordées chacune à un nombre choisi de plots secondaires de connexion et à une borne de connexion destinée à être couplée au microprocesseur. Dans ce cas, chaque ligne primaire est par exemple raccordée à au moins six plots primaires associés à six touches de saisie, et chacune des lignes secondaires peut être raccordée à au moins quatre plots secondaires. Par ailleurs, la première ligne secondaire et deux des lignes primaires peuvent être associées à deux touches de navigation, elles mêmes associées à deux directions principales, et la deuxième ligne secondaire et deux autres des lignes primaires peuvent être associées à deux autres touches de navigation, elles mêmes associées à deux autres directions principales. La ligne secondaire supplémentaire et quatre des lignes primaires peuvent en outre être associées à quatre autres touches de navigation, elles-mêmes associées à quatre directions intermédiaires, respectivement construites à partir de couples de directions principales différentes,
- l'une au moins des lignes primaires peut être raccordée à au moins un plot primaire additionnel associé à une touche de saisie additionnelle. Dans ce cas, le clavier comprend :
   - au moins une deuxième ligne secondaire supplémentaire raccordée à au moins un plot secondaire additionnel, associé à la touche additionnelle et à une borne de connexion, et
   - des troisièmes et quatrièmes moyens de traitement comportant chacun i) au moins une première entrée raccordée à la borne de connexion de la troisième ou quatrième ligne secondaire, ii) une deuxième entrée raccordée à la borne de connexion de la deuxième ligne secondaire supplémentaire, et iii) une sortie propre à être placée soit dans l'état de la troisième ou quatrième ligne secondaire à laquelle elle est raccordée lorsque la deuxième ligne secondaire supplémentaire n'est pas dans son état haut, soit dans l'état haut lorsque la deuxième ligne secondaire supplémentaire est dans son état haut, et destinée à être couplée au microprocesseur de sorte qu'il puisse déterminer chaque touche actionnée, associée à la deuxième ligne secondaire supplémentaire en fonction des états respectifs dans lesquels sont placées les lignes primaires et les sorties des troisièmes et quatrième moyens de traitement. Ces troisièmes et quatrième moyens de traitement peuvent être chacun agencés sous la forme d'un multiplexeur, dont la deuxième entrée est une entrée de commande et qui comprend une troisième entrée placée en permanence dans un état haut et pouvant être couplée à la sortie lorsque la deuxième ligne secondaire supplémentaire est dans son état haut, la première entrée étant alors couplée à la sortie lorsque la deuxième ligne secondaire supplémentaire n'est pas dans son état haut,
- au moins une ligne primaire additionnelle raccordée à au moins trois plots primaires associés à trois autres touches de saisie et à trois plots secondaires raccordés aux troisième, quatrième et à une sixième lignes conductrices secondaires dudit second ensemble.

L'invention propose également un équipement électronique comportant au moins un microprocesseur couplé à un clavier de saisie du type de celui présenté ci-avant.

Un tel équipement comprend préférentiellement des moyens d'analyse chargés d'analyser les états des lignes primaires et des sorties des premiers et seconds moyens de traitement du clavier, et de déduire qu'une touche actionnée est associée soit à la première, respectivement deuxième, ligne secondaire lorsqu'une ligne primaire est placée dans son état haut et que la sortie des premiers, respectivement seconds, moyens de traitement est placée dans son état haut, soit à ladite ligne secondaire supplémentaire lorsqu'une ligne primaire est placée dans son état haut et que les sorties des premiers et seconds moyens de traitement sont placées dans leur état haut.

L'équipement peut également comprendre des moyens de mémorisation stockant une table établissant une correspondance entre des identifiants de touche, des identifiants de lignes primaires et des identifiants de lignes secondaires. Dans ce cas, ses moyens d'analyse sont agencés pour accéder aux moyens de mémorisation afin de déterminer dans la table l'identifiant de touche qui correspond à des états de ligne analysés.

Un tel équipement peut être, par exemple, un ordinateur fixe ou portable (éventuellement de type embarqué), un téléphone fixe ou mobile, un PDA, un dispositif de guidage ou de navigation, ou une console de jeux vidéo. D'une manière générale, l'invention concerne tout équipement comportant un clavier de saisie.

D'autres caractéristiques et avantages de l'invention apparaîtront à l'examen de la description détaillée ci-après, et des dessins annexés, sur lesquels :
- la figure 1 illustre de façon schématique un premier exemple de réalisation d'un clavier de saisie selon l'invention, couplé à un microprocesseur d'équipement électronique, et
- la figure 2 illustre de façon schématique un second exemple de réalisation d'un clavier de saisie selon l'invention, couplé à un microprocesseur d'équipement électronique.

Les dessins annexés pourront non seulement servir à compléter l'invention, mais aussi contribuer à sa définition, le cas échéant.

L'invention a pour objet de permettre l'ajout d'une ou plusieurs touches de saisie à un clavier couplé à un microprocesseur, d'équipement électronique, dont le nombre de pattes de fixation ne peut être augmenté.

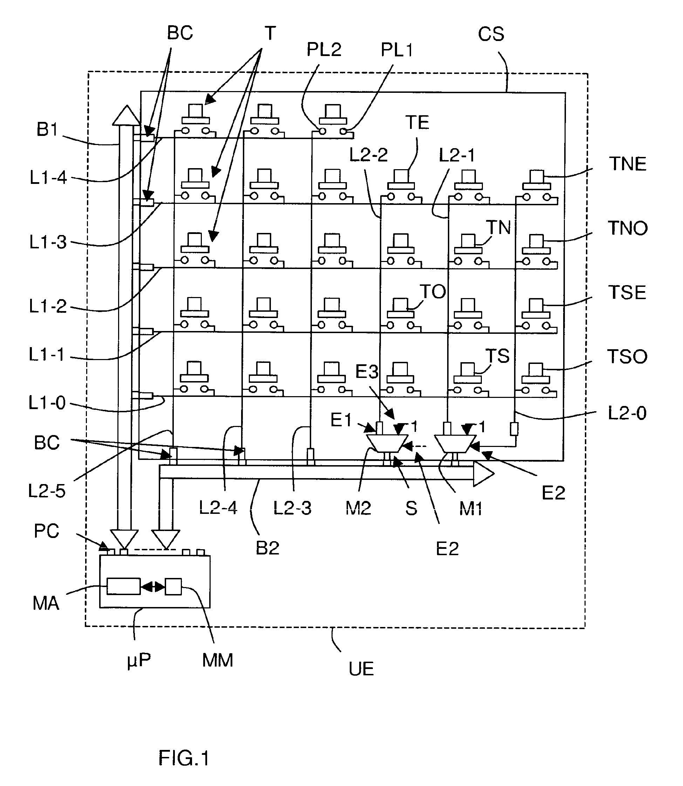

On se réfère tout d'abord à la figure 1 pour décrire un premier exemple de réalisation, non limitatif, d'un clavier de saisie CS selon l'invention.

On considère dans ce qui suit que le clavier de saisie CS est couplé à un microprocesseur µP d'un téléphone mobile UE. Mais, l'invention s'applique à tout type d'équipement électronique muni d'une interface homme/machine permettant la saisie d'informations ou de commandes, comme par exemple un ordinateur fixe ou portable (éventuellement de type embarqué), un téléphone fixe, un PDA, un dispositif de guidage ou de navigation, ou une console de jeux vidéo.

Le clavier CS illustré sur la figure 1 comprend tout d'abord cinq lignes conductrices primaires L1-i (i = 0 à 4) et six lignes conductrices secondaires L2-j (j = 0 à 5). On entend ici par « ligne conductrice de connexion », aussi bien un circuit imprimé (flexible ou rigide) qu'un fil conducteur.

Chaque ligne primaire L1-i est raccordée à une borne de connexion BC et à au moins trois plots primaires de connexion PL1, associés chacun à une touche de saisie T. Plus précisément, dans l'exemple illustré, les quatre premières lignes primaires L1-0 à L1-3 sont chacune raccordées à six plots primaires de connexion PL1 (et donc associées à six touches T), tandis que la cinquième ligne primaire L1-4 n'est raccordée qu'à trois plots primaires de connexion PL1 (et donc associée à trois touches T).

La borne de connexion BC de chaque ligne primaire L1-i est couplée à l'une des pattes de connexion (ou « pins ») PC du microprocesseur µP. Dans l'exemple illustré ce couplage s'effectue par l'intermédiaire d'un premier bus parallèle B1. Mais, d'autres types de couplage peuvent être envisagés, par exemple au moyen de circuits imprimés ou de fils conducteurs.

Chaque ligne secondaire L2-j est également raccordée à une borne de connexion BC et à au moins quatre plots secondaires de connexion PL2, associés chacun à l'une des touches de saisie T. Plus précisément, dans l'exemple illustré, les trois premières lignes secondaires L2-0 à L2-2 sont chacune raccordées à quatre plots secondaires de connexion PL2 (et donc associées à quatre touches T), tandis que les quatrième L2-3, cinquième L2-4 et sixième L2-5 lignes secondaires sont raccordées à cinq plots secondaires de connexion PL2 (et donc associées à cinq touches T).

Chaque touche de saisie T est par exemple un actionneur chargé d'établir, lorsqu'un utilisateur exerce sur lui une brève pression, un contact électrique entre le plot primaire PL1 et le plot secondaire PL2 auxquels il est associé. Ce contact bref provoque, par exemple, un court-circuit momentané entre les ligne primaire L1-i (servant par exemple de sortie) et ligne secondaire L2-j (servant par exemple d'entrée), auxquelles sont respectivement raccordés le plot primaire PL1 et le plot secondaire PL2 contactés.

Lorsqu'une ligne primaire ou secondaire est ainsi court-circuitée, on dit qu'elle est placée dans un état logique dit « haut » (par exemple correspondant à une valeur binaire égale à 1). Ainsi, lorsque le microprocesseur µP détecte un court-circuit sur deux de ses pattes de connexion PC, associées respectivement à une ligne primaire et une ligne secondaire, il sait instantanément que la touche placée à l'intersection de ces lignes primaire et secondaire a été actionnée.

En l'absence de détection de court-circuit sur des pattes de connexion PC, associées respectivement à une ligne primaire et une ligne secondaire, on dit que ces lignes primaire et secondaire sont chacune placées dans un état logique dit « bas » (par exemple correspondant à une valeur binaire égale à 0). En d'autres termes, aucune touche associée à ces deux lignes n'a été actionnée.

Bien entendu, d'autres types de détection peuvent être envisagés, dès lors qu'ils reposent sur l'absence (état bas) ou la présence (état haut) d'un signal analogique ou numérique.

Selon l'invention, parmi les lignes secondaires L2-j, d'une part, au moins deux d'entre elles (ici L2-1 et L2-2) sont raccordées par leur borne de connexion BC à une première entrée E1 de moyens de traitement Mj (j = 1 ou 2), et d'autre part, au moins l'une d'entre elles (ici L2-0) est raccordée par sa borne de connexion BC à une deuxième entrée E2 des moyens de traitement Mj.

Préférentiellement, les moyens de traitement Mj sont des multiplexeurs comportant, d'une part, trois entrées (la première entrée précitée E1 (raccordée à la borne de connexion BC de l'une des deux lignes secondaires L2-1 et L2-2), la deuxième entrée précitée E2 servant d'entrée de commande (raccordée à la borne de connexion BC de la ligne secondaire L2-0), et une troisième entrée E3 définissant un état haut (matérialisé ici par la valeur 1)), et d'autre part, une sortie S.

La deuxième entrée E2 sert à commander l'entrée (parmi E1 et E3) qui doit être connectée à la sortie S, en fonction de l'état de la ligne secondaire L2-0 à laquelle elle est raccordée.

Selon l'invention, si la ligne secondaire L2-0 est dans son état haut (ici égal à 1), alors la sortie S de chaque multiplexeur M1, M2 est raccordée à la troisième entrée E3 correspondante, tandis que si la ligne secondaire L2-0 est dans son état bas (ici égal à 0), alors la sortie S de chaque multiplexeur M1, M2 est raccordée à la première entrée E1 correspondante.

En d'autres termes, si aucune touche T associée à la ligne secondaire L2-0 n'est activée, cette dernière est dans son état bas si bien que la deuxième entrée E2 contraint chaque multiplexeur M1, M2 à raccorder sa première entrée E1 à la sortie S. Par conséquent, si une touche T associée à la ligne secondaire L2-1 ou L2-2 est activée, celle-ci est placée dans son état haut et la sortie S de son multiplexeur M1 ou M2 « délivre », par exemple dans un second bus B2 (raccordé à des pattes de connexion PC du microprocesseur µP), un signal représentatif de l'état haut qui, lorsqu'il parvient au niveau de la patte de connexion PC du microprocesseur µP, avertit ce dernier de l'actionnement d'une touche T de la ligne secondaire L2-1 ou L2-2. Dans le même temps, l'actionnement de la touche T provoque le placement dans l'état haut de la ligne primaire L1-i, à laquelle elle est également associée (via le plot primaire PL1 contacté). Un signal représentatif de l'état haut de la ligne primaire concernée « pénètre » alors dans le premier bus B1, et lorsque ce signal parvient au niveau de la patte de connexion PC du microprocesseur µP, ce dernier est averti de l'actionnement de l'une des touches T de la ligne primaire L1-i.

Dans le cas d'une détection de court-circuit, les signaux représentatifs d'un état haut sont des potentiels électriques identiques. En d'autres termes, le court-circuit place les deux pattes de connexion concernées à un même potentiel électrique.

Pour identifier précisément quelle touche T a été actionnée, le microprocesseur µP dispose préférentiellement d'un module d'analyse MA et d'une table établissant une correspondance entre des identifiants de touche T, des identifiants de lignes primaires L1-i et des identifiants de lignes secondaires L2-j. Lorsque le microprocesseur µP reçoit sur deux de ses pattes de connexion PC un signal haut (par exemple des potentiels électriques identiques), il en informe son module d'analyse MA, qui en déduit les identifiants des lignes primaire et secondaire qui ont générées ces signaux hauts, puis accède à la mémoire MM pour déterminer dans la table l'identifiant de touche qui est stocké en correspondance des identifiants des lignes primaire et secondaire. La touche actionnée est alors identifiée et la commande ou fonction associée peut être effectuée.

Maintenant, si l'une des touches T associées à la ligne secondaire L2-0 est activée, cette dernière est dans son état haut si bien que la deuxième entrée E2 contraint chaque multiplexeur M1, M2 à raccorder sa troisième entrée E3 à la sortie S. La sortie S de chaque multiplexeur M1, M2 « délivre » alors dans le second bus B2 un signal représentatif d'un état haut. Les deux signaux hauts parviennent alors sensiblement en même temps au niveau des deux pattes de connexion PC (correspondant aux lignes secondaires L1-1 et L1-2) du microprocesseur µP. Dans le même temps, l'actionnement de la touche T provoque le placement dans l'état haut de la ligne primaire L1-i, à laquelle elle est également associée (via le plot primaire PL1 contacté). Un signal représentatif de l'état haut de la ligne primaire concernée « pénètre » alors dans le premier bus B1, et parvient au niveau de la patte de connexion PC du microprocesseur µP qui correspond à cette ligne primaire.

Dans ce cas, le microprocesseur µP reçoit sur trois de ses pattes de connexion PC trois signaux hauts. Il en informe son module d'analyse MA, qui est configuré tout d'abord pour déduire des deux signaux hauts, provenant des deux lignes secondaires L2-1 et L2-2, que l'une des touches T de la ligne secondaire L2-0 a été actionnée, et donc l'identifiant de cette dernière. Puis, connaissant les identifiants de la ligne primaire L1-i et de la ligne secondaire L2-0, il accède à la mémoire MM pour déterminer dans la table l'identifiant de touche qui est stocké en correspondance des identifiants des lignes primaire L1-i et secondaire L2-0. La touche actionnée est alors identifiée et la commande ou fonction associée peut être effectuée.

Le module d'analyse MA du clavier de saisie CS selon l'invention peut être réalisé sous la forme de circuits électroniques, de modules logiciels (ou informatiques), ou d'une combinaison de circuits et de logiciels.

Dans l'exemple de clavier illustré sur la figure 1, les touches de saisie référencées TE (associée à la ligne primaire L1-3 et à la ligne secondaire L2-2), TO (associée à la ligne primaire L1-1 et à la ligne secondaire L2-2), TN (associée à la ligne primaire L1-2 et à la ligne secondaire L2-1), et TS (associée à la ligne primaire L1-0 et à la ligne secondaire L2-1), sont des touches dites « de navigation » dédiées à des commandes de déplacement dans les directions, dites « principales », est, ouest, nord et sud, respectivement. Par ailleurs, les touches de saisie référencées TNE (associée à la ligne primaire L1-3 et à la ligne secondaire L2-0), TSE (associée à la ligne primaire L1-1 et à la ligne secondaire L2-0), TNO (associée à la ligne primaire L1-2 et à la ligne secondaire L2-0), et TSO (associée à la ligne primaire L1-0 et à la ligne secondaire L2-0), sont des touches de navigation dédiées à des commandes de déplacement dans les directions, dites «intermédiaires », nord/est, sud/est, nord/ouest et sud/ouest, respectivement.

Ces touches sont par exemple couplées à un organe de navigation , tel qu'un « joystick ».

Par exemple, si l'on actionne la touche TE correspondant à la direction principale est :
- la ligne primaire L1-3 est placée dans son état haut si bien qu'un signal haut « pénètre » dans le premier bus B1 et parvient sur la patte de connexion correspondante PC du microprocesseur µP, permettant ainsi de l'identifier,
- la ligne secondaire L2-2 est placée dans son état haut tandis que la ligne secondaire L2-0 est placée dans son état bas. Les sorties S des multiplexeurs M1 et M2 sont donc raccordées à leurs premières entrées E1. Seule la ligne secondaire L2-2 étant placée dans son état haut, il n'y a donc que la sortie S du multiplexeur M2 qui « délivre » dans le second bus B2 un signal haut qui parvient sur la patte de connexion correspondante PC du microprocesseur µP permettant ainsi de l'identifier.

Connaissant les identifiants de L1-3 et de L2-2, le module d'analyse MA en déduit que c'est la touche TE qui a été actionnée.

Maintenant, si l'on actionne la touche TSE correspondant à la direction intermédiaire sud/est :
- la ligne primaire L1-1 est placée dans son état haut si bien qu'un signal haut « pénètre » dans le premier bus B1 et parvient sur la patte de connexion correspondante PC du microprocesseur µP permettant ainsi de l'identifier,
- la ligne secondaire L2-0 est placée dans son état haut, si bien que les sorties S des multiplexeurs M1 et M2 sont raccordées à leurs troisièmes entrées E3. Les sorties S des multiplexeurs M1 et M2 « délivrent » alors chacune dans le second bus B2 un signal haut qui parvient sur la patte de connexion correspondante PC du microprocesseur µP, permettant ainsi d'identifier les lignes secondaires L2-1 et L2-2.

En présence des identifiants des deux lignes secondaires L2-1 et L2-2, le module d'analyse MA en déduit qu'une touche de la ligne secondaire L2-0 a été actionnée, et donc l'identifiant de L2-0. Puis, connaissant les identifiants de L1-3 et de L2-0, le module d'analyse MA en déduit que c'est la touche TSE qui a été actionnée.

Lorsque l'une des touches T associées à l'une des lignes secondaires L2-3 à L2-5, dont les bornes de connexion BC sont « directement » connectées au second bus B2, est actionnée, la procédure de détermination de cette touche est classique. Plus précisément, l'actionnement d'une touche T entraîne le placement dans l'état haut de la ligne primaire et de la ligne secondaire associées. Leurs bornes de connexion BC « délivrent » alors dans les premier B1 et second B2 bus des signaux hauts qui parviennent sur les deux pattes de connexion correspondantes PC du microprocesseur µP permettant ainsi d'identifier les lignes primaire et secondaire. Connaissant les identifiants des deux lignes primaire et secondaire, le module d'analyse MA peut alors en déduire l'identifiant de la touche TE actionnée.

Il est important de noter que les bornes de connexion BC des lignes secondaires L2-j qui sont couplées au bus B2 par l'intermédiaire d'un multiplexeur Mj ne sont pas forcément identiques aux bornes de connexion BC des lignes secondaires L2-j qui sont « directement » couplées au bus B2.

Il est également important de noter que les premier B1 et second B2 bus peuvent ne constituer qu'un seul et même bus.

Grâce à l'invention, il est donc possible de rajouter une ou plusieurs touches de saisie dans un clavier, sans que cela ne nécessite l'ajout de pattes de connexion au niveau du microprocesseur. Ainsi, dans l'exemple illustré quatre touches de navigation intermédiaires TNE, TNO, TSE et TSO ont été ajoutées aux quatre touches de navigation principales TE, TO, TN et TS du clavier CS afin d'offrir quatre commandes de déplacement supplémentaires, pour un même nombre de pattes de connexion (ici 10) que dans un clavier traditionnel.

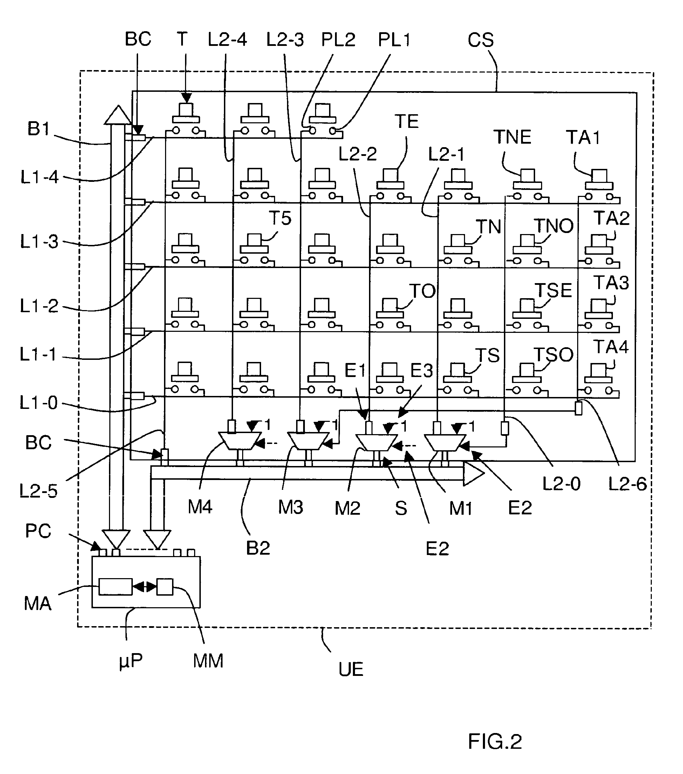

On se réfère maintenant à la figure 2 pour décrire un second exemple de réalisation d'un clavier de saisie CS selon l'invention. Il s'agit plus précisément d'une variante du premier exemple, décrit précédemment en référence à la figure 1.

Ce second exemple reprend l'intégralité du premier exemple et comprend en complément une autre ligne de connexion secondaire additionnelle L2-6 couplée à deux multiplexeurs additionnels M3 et M4 respectivement raccordés aux bornes de connexion BC des quatrième L2-3 et cinquième L2-4 lignes secondaires.

Cette ligne de connexion secondaire additionnelle L2-6 et les deux multiplexeurs additionnels M3 et M4 permettent de rajouter au clavier CS de la figure 1 quatre nouvelles touches additionnelles TA1 à TA4, sans augmentation du nombre de pattes de connexion PC du microprocesseur µP. La ligne de connexion secondaire additionnelle L2-6 et les deux multiplexeurs additionnels M3 et M4 fonctionnent de la même façon que la ligne de connexion secondaire L2-0 et les deux multiplexeurs additionnels M1 et M2.

Par exemple, si l'on actionne la touche T5 associée à la ligne primaire L1-2 et à la ligne secondaire L2-4 :
- la ligne primaire L1-2 est placée dans son état haut si bien qu'un signal haut « pénètre » dans le premier bus B1 et parvient sur la patte de connexion correspondante PC du microprocesseur µP, permettant ainsi de l'identifier,
- la ligne secondaire L2-4 est placée dans son état haut tandis que la ligne secondaire L2-6 est placée dans son état bas. Les sorties S des multiplexeurs M3 et M4 sont donc raccordées à leurs premières entrées E1. Seule la ligne secondaire L2-4 étant placée dans son état haut, il n'y a donc que la sortie S du multiplexeur M4 qui « délivre » dans le second bus B2 un signal haut qui parvient sur la patte de connexion correspondante PC du microprocesseur µP, permettant ainsi de l'identifier.

Connaissant les identifiants de L1-2 et de L2-4, le module d'analyse MA en déduit que c'est la touche T5 qui a été actionnée.

Maintenant, si l'on actionne la touche TA1 associée à la ligne primaire L1-3 et à la ligne secondaire L2-6 :
- la ligne primaire L1-3 est placée dans son état haut si bien qu'un signal haut « pénètre » dans le premier bus B1 et parvient sur la patte de connexion correspondante PC du microprocesseur µP, permettant ainsi de l'identifier,
- la ligne secondaire L2-6 est placée dans son état haut, si bien que les sorties S des multiplexeurs M3 et M4 sont raccordées à leurs troisièmes entrées E3. Les sorties S des multiplexeurs M3 et M4 « délivrent » alors chacune dans le second bus B2 un signal haut qui parvient sur la patte de connexion correspondante PC du microprocesseur µP, permettant ainsi d'identifier les lignes secondaires L2-3 et L2-4.

En présence des identifiants des deux lignes secondaires L2-3 et L2-4, le module d'analyse MA en déduit qu'une touche de la ligne secondaire L2-6 a été actionnée, et donc l'identifiant de L2-6. Puis, connaissant les identifiants de L1-3 et de L2-6, le module d'analyse MA en déduit que c'est la touche TA1 qui a été actionnée.

L'invention ne se limite pas aux modes de réalisation de clavier de saisie et d'équipement électronique décrits ci-avant, seulement à titre d'exemple, mais elle englobe toutes les variantes que pourra envisager l'homme de l'art dans le cadre des revendications ci-après.

De très nombreuses configurations, différentes de celles décrites ci-avant, peuvent en effet être envisagées, comportant plus ou moins de lignes primaires et/ou de lignes secondaires et un nombre plus important de moyens de traitement couplés aux lignes secondaires qui ne sont pas « directement » reliées au bus (ou à tout autre moyen de raccordement aux pattes de connexion du microprocesseur).

D'une manière générale, l'invention s'applique à tout clavier de saisie comportant :
- au moins deux lignes conductrices primaires raccordées chacune à au moins un plot primaire de connexion et à une borne de connexion,
- au moins des première, deuxième et troisièmes lignes conductrices secondaires raccordées chacune à au moins un plot secondaire de connexion et à une borne de connexion,
- au moins trois touches de saisie pouvant chacune établir, en cas d'actionnement, un contact entre un plot primaire de l'une des lignes primaires et un plot secondaire de l'une des lignes secondaires, afin de placer chacune de ces deux lignes primaire et secondaire dans un état haut au niveau de sa borne de connexion, et
- des premiers et seconds moyens de traitement comportant chacun :
   - au moins une première entrée raccordée à la borne de connexion de la première ou deuxième ligne secondaire,
   - une deuxième entrée raccordée à la borne de connexion de la troisième ligne secondaire, et
   - une sortie pouvant être placée soit dans l'état de la première ou deuxième ligne secondaire à laquelle elle est raccordée lorsque la troisième ligne secondaire n'est pas dans son état haut, soit dans l'état haut lorsque la troisième ligne secondaire est dans son état haut, et destinée à être couplée, tout comme chaque borne de connexion des lignes primaires à un microprocesseur de l'équipement de sorte qu'il puisse déterminer chaque touche actionnée en fonction des états respectifs dans lesquels sont placées les lignes primaires et les sorties des premiers et seconds moyens de traitement.

Par ailleurs, l'invention n'est pas limitée aux moyens de traitement présentés ci-avant.

## Revendications

1. Clavier de saisie (CS) pour un équipement électronique (UE) disposant d'un microprocesseur (µP) comprenant un nombre limité P de pattes de connexion (PC) destinées à être couplées avec le clavier, le clavier étant du type comprenant :
- un premier ensemble de N lignes conductrices primaires (L1-i) et un second ensemble de M lignes conductrices secondaires (L2-1 à L2-5), les nombres entiers N et M étant choisis de sorte que leur somme soit égale au nombre limité P de pattes de connexion (PC), chaque ligne conductrice primaire et chaque ligne conductrice secondaire étant raccordée à des plots de connexion respectivement primaires (PL1) et secondaires (PL2) et à une borne de connexion (BC) destinée à être couplée à une patte de connexion (PC) du microprocesseur (µP) ;
- un nombre maximum K de touches de saisie correspondant au produit des nombres entiers N et M, chacune desdites touches de saisie pouvant établir, en cas d'actionnement, un contact avec l'un des plots primaires d'une ligne conductrice primaire dudit premier ensemble et l'un des plots secondaires de l'une des lignes conductrices secondaires dudit second ensemble, de manière à placer les deux lignes conductrices correspondantes dans un état logique dit « haut » permettant au microprocesseur d'identifier la touche de saisie effectivement actionnée ;
**caractérisé en ce qu'**il comprend en outre au moins :
- une ligne conductrice secondaire (L2-0) supplémentaire raccordée à des plots de connexion secondaires associés à des touches de saisie supplémentaires dont l'actionnement place ladite ligne conductrice secondaire supplémentaire dans un état logique «dit « haut » ;
- des premiers (M1) et seconds (M2) moyens de traitement comportant chacun au moins :
- une première entrée (E1) raccordée à la borne de connexion (BC) d'une première (L2-1), respectivement d'une deuxième (L2-2), ligne conductrice secondaire dudit second ensemble,
- une deuxième entrée (E2) raccordée à une borne de connexion de la ligne conductrice secondaire supplémentaire (L2-0), et
- une sortie (S) propre à être placée soit dans l'état de la première entrée (E1) lorsque la ligne secondaire supplémentaire (L2-0) n'est pas dans son état haut, soit dans un état logique « haut » lorsque la ligne secondaire supplémentaire (L2-0) est dans son état haut,
chaque sortie (S) étant destinée à être couplée à l'une des pattes de connexion du microprocesseur (µP) de sorte qu'il puisse déterminer chaque touche actionnée parmi le nombre maximum K de touche de saisie, et les touches de saisie supplémentaires (T), en fonction des états respectifs dans lesquels sont placées d'une part, les lignes primaires (L1-i) et d'autre part, les sorties (S) des premiers (M1) et seconds (M2) moyens de traitement.

2. Clavier selon la revendication 1, **caractérisé en ce que** lesdits premiers (M1) et seconds (M2) moyens de traitement sont chacun agencés sous la forme d'un multiplexeur dont la deuxième entrée (E2) est une entrée de commande et comprenant une troisième entrée (E3) placée en permanence dans un état haut et propre à être couplée à la sortie (S) lorsque ladite ligne secondaire supplémentaire (L2-0) est dans son état haut, ladite première entrée (E1) étant couplée à ladite sortie (S) lorsque ladite ligne secondaire supplémentaire (L2-0) n'est pas dans son état haut.

3. Clavier selon l'une des revendications 1 et 2, **caractérisé en ce que** le premier ensemble comprend au moins quatre lignes conductrices primaires (L2-i) raccordées chacune à un nombre choisi de plots primaires de connexion (PL1) et à une borne de connexion (BC) destinée à être couplée audit microprocesseur (µP), et **en ce que** le second ensemble comprend au moins cinq lignes conductrices secondaires raccordées chacune à un nombre choisi de plots secondaires de connexion (PL2) et à une borne de connexion (BC) destinée à être couplée audit microprocesseur (µP).

4. Clavier selon la revendication 3, **caractérisé en ce que** chaque ligne primaire (L1-i) est raccordée à au moins six plots primaires (PL1) associés à six touches de saisie (T), et chacune desdites lignes secondaires (L2-1 à L2-5) et de la ligne secondaire supplémentaire (L2-0) est raccordée à au moins quatre plots secondaires (PL2).

5. Clavier selon l'une des revendications 3 et 4, **caractérisé en ce que** ladite première ligne secondaire (L2-1) et deux desdites lignes primaires (L1-3,L1-1) sont associées à deux touches dites « de navigation » (TE, TO), elles mêmes associées à deux directions dites « principales », et ladite deuxième ligne secondaire (L2-2) et deux autres desdites lignes primaires (L1-2, L2-0) sont associées à deux autres touches de navigation (TN,TS), elles mêmes associées à deux autres directions principales.

6. Clavier selon la revendication 5, **caractérisé en ce que** ladite ligne secondaire supplémentaire (L2-0) et quatre desdites lignes primaires (L1-0 à L1-3) sont associées à quatre autres touches de navigation (TNE,TNO,TSE,TSO), elles mêmes associées à quatre directions dites « intermédiaires », respectivement construites à partir de couples de directions principales différentes.

7. Clavier selon l'une des revendications 3 à 6, **caractérisé en ce que** l'une au moins desdites lignes primaires (L1-i) est raccordée à au moins un plot primaire (PL1) additionnel associé à une touche de saisie additionnelle (TA1-TA4), et **en ce qu'**il comprend i) au moins une deuxième ligne secondaire supplémentaire (L2-6) raccordée à au moins un plot secondaire (LP2) additionnel, associé à ladite touche additionnelle et à une borne de connexion (BC), et ii) des troisièmes (M3) et quatrièmes (M4) moyens de traitement comportant chacun au moins une première entrée (E1) raccordée à la borne de connexion (BC) troisième (L2-3) ou quatrième (L2-4) ligne secondaire du second ensemble, une deuxième entrée (E2) raccordée à la borne de connexion (BC) de la deuxième ligne secondaire supplémentaire (L2-6), et une sortie (S) propre à être placée soit dans l'état de la troisième (L2-3) ou quatrième (L2-4) ligne secondaire à laquelle elle est raccordée lorsque la deuxième ligne secondaire supplémentaire (L2-6) n'est pas dans son état haut, soit dans l'état haut lorsque la deuxième ligne secondaire supplémentaire (L2-6) est dans son état haut, et destinée à être couplée, audit microprocesseur (µP) de sorte qu'il puisse déterminer chaque touche (TA1-TA4) actionnée, associée à ladite deuxième ligne secondaire supplémentaire (L2-6) en fonction des états respectifs dans lesquels sont placées les lignes primaires (L1-i) et les sorties (S) des troisième (M3) et quatrième (M4) moyens de traitement.

8. Clavier selon la revendication 7, **caractérisé en ce que** lesdits troisième (M3) et quatrième (M4) moyens de traitement sont chacun agencés sous la forme d'un multiplexeur dont la deuxième entrée (E2) est une entrée de commande et comprenant une troisième entrée (E3) placée en permanence dans un état haut et propre à être couplée à la sortie (S) lorsque ladite deuxième ligne secondaire supplémentaire (L2-6) est dans son état haut, ladite première entrée (E1) étant couplée à ladite sortie (S) lorsque ladite deuxième ligne secondaire supplémentaire (L2-6) n'est pas dans son état haut.

9. Clavier selon l'une des revendications 3 à 8, **caractérisé en ce qu'**il comprend au moins une ligne primaire additionnelle (L2-4) raccordée à au moins trois plots primaires (PL1) associés à trois autres touches de saisie (T) et à trois plots secondaires (PL2) raccordés auxdites troisième (L2-3), quatrième (L2-4) et à une cinquième (L2-5) lignes conductrices secondaires dudit second ensemble.

10. Equipement électronique (UE) comportant au moins un microprocesseur (µP), **caractérisé en ce qu'**il comprend un clavier de saisie (CS) selon l'une des revendications 1 à 9, couplé audit microprocesseur (µP).

11. Equipement selon la revendication 10, **caractérisé en ce qu'**il comprend des moyens d'analyse (MA) agencés pour analyser les états des lignes primaires (L1-i) et des sorties (S) d'au moins lesdits premiers (M1) et seconds (M2) moyens de traitement dudit clavier (CS), et pour déduire qu'une touche (T) actionnée est associée soit à la première (L2-1), respectivement deuxième (L2-2), ligne secondaire lorsqu'une ligne primaire (L1-i) est placée dans son état haut et que la sortie desdits premiers (L2-1), respectivement seconds (L2-2), moyens de traitement est placée dans son état haut, soit à la première ligne secondaire supplémentaire (L2-0) lorsqu'une ligne primaire (L1-i) est placée dans son état haut et que les sorties (S) desdits premiers (M1) et seconds (M2) moyens de traitement sont placées dans leur état haut.

12. Equipement selon la revendication 11, **caractérisé en ce qu'**il comprend des moyens de mémorisation (MM) propres à stocker une table établissant une correspondance entre des identifiants de touche (T), des identifiants de lignes primaires (L1-i) et des identifiants de lignes secondaires (L2-j), et **en ce que** lesdits moyens d'analyse (MA) sont agencés pour accéder auxdits moyens de mémorisation (MM) pour déterminer dans ladite table un identifiant de touche (T) correspondant à des états de ligne analysés.

13. Equipement selon l'une des revendications 11 et 12, **caractérisé en ce qu'**il est choisi dans un groupe comprenant au moins les téléphones fixes ou mobiles, les assistants personnels numériques, les ordinateurs fixes ou portables et les consoles de jeux.

## Claims

1. Data input keyboard (CS) for electronic equipment (UE) provided with a microprocessor (µP) comprising a limited number P of connection pins (PC) intended to be coupled to the keyboard, the keyboard being of the type comprising:
- a first group of N primary conductor lines (L1-i)and a second group of M secondary conductor lines (L2-2 to L2-5), the integers N and M being chosen so that their sum equals the limited number P of connection pins (PC), each primary conductor line and each secondary conductor line being connected to primary (PL1) and secondary (PL2) connection pads respectively and to a connection terminal (BC) intended to be coupled to a connection pin (PC) of the microprocessor (µP).
- a maximum number K of input keys corresponding to the product of the integers N and M, each of said input keys, when actuated, being capable of setting up a contact with one of the primary pads of a primary conductor line of said first group and one of the secondary pads of one of the secondary conductor lines of said second group, so as to place the two corresponding conductor lines in a so-called "high" logic state allowing the microprocessor to identify the input key effectively actuated;
**characterized in that** it also comprises at least:
- one additional secondary conductor line connected to secondary connection pads associated with additional input keys whose actuation places said additional secondary conductor line in a so-called "high" logic state:
- first (M1) and second (M2) processing means each comprising at least:
• a first input (E1) connected to the connection terminal (BC) of respectively a first (L2-1) and second (L2-2) secondary conductor line of said second group,
• a second input (E2) connected to a connection terminal of the additional secondary conductor line (L2-0), and
• an output (S) able to be placed either in the logic state of the first input (E1) when the additional secondary line (L2-0) is not in its high state, or in a "high" logic state when the additional secondary line (L2-0) is in its high state,
each output (S) being intended to be coupled to one of the connection pins of the microprocessor (µP) so that the microprocessor is able to determine each actuated key among the maximum number K of input keys and the additional input keys (T), in relation to the respective states taken up firstly by the primary lines (L1-i) and secondly by the outputs (S) of the first (M1) and second (M2) processing means.

2. Keyboard according to claim 1, **characterized in that** said first (M1) and second (M2) processing means are each arranged in the form of a multiplexer whose second input (E2) is a command input, and comprising a third input (E3) permanently placed in a high state and able to be coupled to the output (S) when said additional secondary line (L2-0) is in its high state, said first input (E1) being coupled to said output (S) when said additional secondary line (L2-0) is not in its high state.

3. Keyboard according to either of claims 1 and 2, **characterized in that** the first group comprises at least four primary conductor lines (L2-i) each connected to a chosen number of primary connection pads (PL1) and to a connection terminal (BC) intended to be coupled to said microprocessor (µP), and **in that** the second group comprises at least five secondary conductor lines each connected to a chosen number of secondary connection pads (PL2) and to a connection terminal (BC) intended to be coupled to said microprocessor (µP).

4. Keyboard according to claim 3, **characterized in that** each primary line (L1-i) is connected to at least six primary pads (PL1) associated with six input keys (T), and each said secondary line (L2-1 to L2-5) and additional secondary line (L2-0) is connected to at least four secondary pads (PL2).

5. Keyboard according to either of claims 3 and 4, **characterized in that** said first secondary line (L2-1) and two of said primary lines (L1-3, L1-1) are associated with two so-called "navigation" keys (TE,TO), themselves associated with two so-called "main" directions, and said second secondary line (L2-2) and two other of said primary lines (L1-2, L2-0) are associated with two other navigation keys (TN,TS), themselves associated with two other main directions.

6. Keyboard according to claim 5, **characterized in that** said additional secondary line (L2-0) and four of said primary lines (L1-0 to L1-3) are associated with four other navigation keys (TNE, TNO, TSE, TSO), themselves associated with four so-called "intermediate" directions respectively constructed from pairs of the different main directions.

7. Keyboard according to any of claims 3 to 6, **characterized in that** at least one of said primary lines (L1-i) is connected to at least one additional primary pad (PL1) associated with an additional input key (TA1-TA4), and **in that** it comprises i) at least one second additional secondary line (L2-6) connected to at least one additional secondary pad (LP2), associated with said additional key and with a connection terminal (BC), and ii) third (M3) and fourth (M4) processing means each comprising at least one first input (E1) connected to the connection terminal (BC) of the third (L2-3) or fourth (L2-4) secondary line of the second group, a second input (E2) connected to the connection terminal (BC) of the second additional secondary line (L2-6), and an output (S) able to be placed either in the state of the third (L2-3) or fourth (L2-4) secondary line with which it is connected when the second additional secondary line (L2-6) is not in its high state, or in the high state when the second additional secondary line (L2-6) is in its high state, and intended to be coupled to said microprocessor (µP) so that the microprocessor is able to determine each actuated key (TA1-TA4) associated with said second additional secondary line (L2-6) in relation to the respective states taken up by the primary lines (L1-i) and the outputs (S) of the third (M3) and fourth (M4) processing means.

8. Keyboard according to claim 7, **characterized in that** said third (M3) and fourth (M4) processing means are each arranged in the form of a multiplexer whose second input (E2) is a command input and comprising a third input (E3) permanently placed in a high state and able to be coupled to the output (S) when said second additional secondary line (L2-6) is in its high state, said first input (E1) being coupled to said output (S) when said second additional secondary line (L2-6) is not in its high state.

9. Keyboard according to any of claims 3 to 8, **characterized in that** it comprises at least one additional primary line (L2-4) connected to at least three primary pads (PL1) associated with three other input keys (T) and with three secondary pads (PL2) connected to said third (L2-3), fourth (L2-4) and to a fifth (L2-5) secondary conductor line of said second group.

10. Electronic equipment (UE) comprising at least one microprocessor (µP), **characterized in that** it comprises a data input keyboard (CS) according to any of claims 1 to 9 coupled to said microprocessor (µP).

11. Equipment according to claim 10, **characterized in that** it comprises analysis means (MA) arranged to an analyze the states of the primary lines (L1-i) and of the outputs (S) of at least said first (M1) and second (M2) processing means of said keyboard (CS), and to deduce that an actuated key (T) is associated either with the first (L2-1) respectively second (L2-2) secondary line when a primary line (L1-i) is placed in its high state and when the output of said first (L2-1) respectively second (L2-2) processing means is placed in its high state, or is associated with the first additional secondary line (L2-0) when a primary line (L1-i) is placed in its high state and when the outputs of said first (M1) and second (M2)processing means are placed in their high state.

12. Equipment according to claim 11, **characterized in that** it comprises memorizing means (MM) able to store a table giving the correspondence between identifiers of keys (T), identifiers of primary lines (L1-i) and identifiers of secondary lines (L2-j), and **in that** said analysis means (MA) are arranged to access said memorizing means (MM) to determine in said table the identifier of a key (T) corresponding to the analyzed line states.

13. Equipment according to either of claims 11 and 12, **characterized in that** it is chosen from a group at least consisting of landline or mobile telephones, personal digital assistants, desktop or laptop computers and game consoles.

## Patentansprüche

1. Eingabetastatur (CS) für eine elektronische Vorrichtung (UE), die über einen Mikroprozessor (µP) verfügt, der eine begrenzte Anzahl P von Verbindungsstücken (PC), die dafür vorgesehen sind, mit der Tastatur verbunden zu werden, wobei die Tastatur von dem Typ ist, der umfasst:
- eine erste Menge von N primären leitfähigen Leitungen (L1-i) und eine zweite Menge von M sekundären leitfähigen Leitungen (L2-1 bis L2-5) wobei die ganzen Zahlen N und M derart ausgewählt sind, dass ihre Summe gleich der begrenzten Anzahl P von Verbindungsstücken (PC) ist, wobei jede primäre leitfähige Leitung und jede sekundäre leitfähige Leitung mit primären (PL1) bzw. sekundären (PL2) Verbindungskontaktstücken und einer Verbindungsklemme (BC), die dafür vorgesehen ist, mit einem Verbindungsstück (PC) des Mikroprozessors (µP) verbunden zu werden;
- eine Maximalzahl K von Eingabetasten, die dem Produkt der ganzen Zahlen N und M entspricht, wobei jede der Eingabetasten im Falle der Betätigung einen Kontakt mit einem der primären Kontaktstücke einer primären leitfähigen Leitung der ersten Menge und einem der sekundären Kontaktstücke einer sekundären leitfähigen Leitung der zweiten Menge aufbauen kann, um die beiden entsprechenden leitfähigen Leitungen in einen "hoch" genannten logischen Zustand zu bringen, der dem Mikroprozessor gestattet, die tatsächlich betätigte Eingabetaste zu identifizieren;
**dadurch gekennzeichnet, dass** sie außerdem wenigstens umfasst:
- eine zusätzliche sekundäre leitfähige Leitung (L2-0), die an die sekundären Verbindungskontaktstücke angeschlossen ist, die zu zusätzlichen Eingabetasten gehören, deren Betätigung die zusätzliche sekundäre leitfähige Leitung in einen "hoch" genannten logischen Zustand bringt;
- erste (M1) und zweite (M2) Verarbeitungsmittel, die jeweils wenigstens umfassen:
- einen ersten Eingang (E1), der mit der Verbindungsklemme (BC) einer ersten (L2-1) bzw. einer zweiten (L2-2) sekundären leitfähigen Leitung der zweiten Menge verbunden ist,
- einen zweiten Eingang (E2), der mit einer Verbindungsklemme der zusätzlichen sekundären leitfähigen Leitung (L2-0) verbunden ist, und
- einen Ausgang (S), der dafür geeignet ist, entweder in den Zustand des ersten Eingangs (E1), wenn die zusätzliche sekundäre Leitung (L2-0) sich nicht in ihrem hohen Zustand befindet, oder in den logischen Zustand "hoch" gebracht zu werden, wenn sich die zusätzliche sekundäre Leitung (L2-0) in ihrem hohen Zustand befindet,
wobei jeder Ausgang (S) dafür vorgesehen ist, mit einem Verbindungsstück des Mikroprozessors (µP) verbunden zu werden, so dass er jede betätigte Taste unter der Maximalzahl K von Eingabetasten und die zusätzlichen Eingabetasten (T) in Abhängigkeit von den jeweiligen Zuständen bestimmen kann, in die einerseits die primären Leitungen (L1-i) und andererseits die Ausgänge (S) der ersten (M1) und zweiten (M2) Verarbeitungsmittel gebracht sind.

2. Tastatur nach Anspruch 1, **dadurch gekennzeichnet, dass** die ersten (M1) und zweiten (M2) Verarbeitungsmittel jeweils in Form eines Multiplexers angeordnet sind, dessen zweiter Eingang (E2) ein Steuereingang ist und der einen dritten Eingang (E3) umfasst, der dauernd in einen hohen Zustand gebracht und geeignet ist, mit dem Ausgang (S) verbunden zu werden, wenn sich die zusätzliche sekundäre Leitung (L2-0) nicht im hohen Zustand befindet.

3. Tastatur nach einem der Ansprüche 1 und 2, **dadurch gekennzeichnet, dass** die erste Menge wenigstens vier primäre leitfähige Leitungen (L2-i) umfasst, die jeweils an eine ausgewählte Anzahl von primären Verbindungskontaktstücken (PL1) und eine Verbindungsklemme (BC) angeschlossen sind, die dafür vorgesehen ist, mit dem Mikroprozessor (µP) verbunden zu werden, und dass die zweite Menge wenigstens fünf sekundäre leitfähige Leitungen umfasst, die jeweils an eine ausgewählte Anzahl von sekundären Verbindungskontaktstücken (PL2) und an eine Verbindungsklemme (BC) angeschlossen sind, die dafür vorgesehen ist, mit dem Mikroprozessor verbunden zu werden.

4. Tastatur nach Anspruch 3, **dadurch gekennzeichnet, dass** jede primäre Leitung (L1-i) an wenigstens sechs primäre Kontaktstücke (PL1) angeschlossen ist, die zu sechs Eingabetasten (T) gehören, und jede der sekundären Leitungen (L2-1 bis L2-5) und der zusätzlichen sekundären Leitung (L2-0) an wenigstens vier sekundäre Kontaktstücke (PL2) angeschlossen ist.

5. Tastatur nach einem der Ansprüche 3 und 4, **dadurch gekennzeichnet, dass** die erste sekundäre Leitung (L2-1) und zwei der primären Leitungen (L1-3, L1-1) zu zwei "Navigationstasten" genannten Tasten (TE, TO) gehören, die selbst zu zwei "Hauptrichtungen" genannten Richtungen gehören, und die zweite sekundäre Leitung (L2-2) und zwei weitere der primären Leitungen (L1-2, L2-0) zu zwei weiteren Navigationstasten (TN, TS) gehören, die selbst zu zwei weiteren Hauptrichtungen gehören.

6. Tastatur nach Anspruch 5, **dadurch gekennzeichnet, dass** die zweite zusätzliche sekundäre Leitung (L2-0) und vier der primären Leitungen (L1-0 bis L1-3) zu vier weiteren Navigationstasten (TNE, TNO, TSE, TSO) gehören, die selbst zu vier "Zwischenrichtungen" genannten Richtungen gehören, die jeweils ausgehend von Paaren aus verschiedenen Hauptrichtungen gebildet sind.

7. Tastatur nach einem der Ansprüche 3 bis 6, **dadurch gekennzeichnet, dass** wenigstens eine der primären Leitungen (L1-i) an wenigstens ein zusätzliches primäres Kontaktstück (PL1) angeschlossen ist, das zu einer zusätzlichen Eingabetaste (TA1-TA4) gehört, und dass sie umfasst i) wenigstens eine zweite zusätzliche sekundäre Leitung (L2-6), die an wenigstens ein zusätzliches Kontaktstück (LP2), das zur zusätzlichen Taste gehört, und eine Verbindungsklemme (BC) angeschlossen ist, und ii) dritte (M3) und vierte (M4) Verarbeitungsmittel, die jeweils wenigstens einen ersten Eingang (E1), der an die Verbindungsklemme (BC) der dritten (L2-3) oder vierten (L2-4) sekundären Leitung der zweiten Menge angeschlossen ist, einen zweiten Eingang (E2), der an die Verbindungsklemme (BC) der zweiten zusätzlichen sekundären Leitung (L2-6) angeschlossen ist, und einen Ausgang (S) aufweisen, der geeignet ist, entweder in den Zustand der dritten (L2-3) oder vierten (L2-4) sekundären Leitung, an die er angeschlossen ist, wenn sich die zweite zusätzliche sekundäre Leitung (L2-6) nicht in ihrem hohen Zustand befindet, oder in den hohen Zustand gebracht zu werden, wenn sich die zweite zusätzliche sekundäre Leitung (L2-6) in ihrem hohen Zustand befindet, und dafür vorgesehen ist, mit dem Mikroprozessor (µP) so verbunden zu werden, dass er jede betätigte Taste (TA1-TA4), die zur zweiten zusätzlichen sekundären Leitung (L2-6) gehört, in Abhängigkeit von den jeweiligen Zuständen bestimmen kann, in die die primären Leitungen (L1-i) und die Ausgänge (S) der dritten (M3) und vierten (M4) Verarbeitungsmittel gebracht sind.

8. Tastatur nach Anspruch 7, **dadurch gekennzeichnet, dass** die dritten (M3) und vierten (M4) Verarbeitungsmittel jeweils in Form eines Multiplexers angeordnet sind, dessen zweiter Eingang (E2) ein Steuereingang ist und der einen dritten Eingang (E3) umfasst, der dauernd in einen hohen Zustand gebracht und geeignet ist, mit dem Ausgang (S) verbunden zu werden, wenn sich die zweite zusätzliche sekundäre Leitung (L2-6) in ihrem hohen Zustand befindet, wobei der erste Eingang (E1) mit dem Ausgang (S) verbunden wird, wenn sich die zweite zusätzliche sekundäre Leitung (L2-6) nicht in ihrem hohen Zustand befindet.

9. Tastatur nach einem der Ansprüche 3 bis 8, **dadurch gekennzeichnet, dass** sie wenigstens eine zusätzliche primäre Leitung (L2-4) umfasst, die an wenigstens drei primäre Kontaktstücke (PL1), die zu drei Eingabetasten (T) gehören, und an drei sekundäre Kontaktstücke (PL2) angeschlossen ist, die an die dritten (L2-3), vierten (L2-4) und eine fünfte (L2-5) sekundäre leitfähige Leitung der zweiten Menge angeschlossen sind.

10. Elektronische Vorrichtung (UE), die wenigstens einen Mikroprozessor (µP) umfasst, **dadurch gekennzeichnet, dass** sie eine Eingabetaste (CS) nach einem der Ansprüche 1 bis 9 umfasst, die mit dem Mikroprozessor (µP) verbunden ist.

11. Vorrichtung nach Anspruch 10, **dadurch gekennzeichnet, dass** sie Analysemittel (MA) umfasst, die dafür eingerichtet sind, die Zustände der primären Leitungen (L1-i) und der Ausgänge (S) wenigstens der ersten (M1) und zweiten (M2) Verarbeitungsmittel der Tastatur (CS) zu analysieren und zu folgern, dass eine betätigte Taste (T) entweder zur ersten (L2-1) bzw. zweiten (L2-2) sekundären Leitung, wenn die primäre Leitung (L1-i) in ihren hohen Zustand gebracht wurde und der Ausgang der ersten (L2-1) bzw. zweiten (L2-2) Verarbeitungsmittel in seinen hohen Zustand gebracht wurde, oder zur ersten zusätzlichen sekundären Leitung (L2-0) gehört, wenn eine primäre Leitung (L1-i) in ihren hohen Zustand gebracht wurde und die Ausgänge der ersten (M1) und zweiten (M2) Verarbeitungsmittel in ihren hohen Zustand gebracht wurden.

12. Vorrichtung nach Anspruch 11, **dadurch gekennzeichnet, dass** sie Speichermittel (MM) umfasst, die geeignet sind, eine Tabelle zu speichern, die eine Entsprechung zwischen den Kennungen der Tasten (T), den Kennungen der primären Leitungen (L1-i) und den Kennungen der sekundären Leitungen (L2-j) festlegt, und dass die Analysemittel (MA) dafür eingerichtet sind, auf die Speichermittel (MM) zuzugreifen, um in der Tabelle eine Kennung fiir die Taste (T) zu ermitteln, die den analysierten Leitungszuständen entspricht.

13. Vorrichtung nach einem der Ansprüche 11 und 12, **dadurch gekennzeichnet, dass** sie aus einer Gruppe ausgewählt ist, die wenigstens die Festnetz- oder Mobiltelefone, die Minicomputer, die stationären oder tragbaren Rechner und die Spielekonsolen umfasst.
